# NEUE EUROPÄISCHE PATENTSCHRIFT

(11) **EP 0 600 063 B2**
(45) Veröffentlichungstag und Bekanntmachung des Hinweises auf die Entscheidung über den Einspruch: **10.07.2002**
(45) Hinweis auf die Patenterteilung: 03.09.1997
(21) Anmeldenummer: 93912923.5
(22) Anmeldetag: 09.06.1993
(51) Int. Cl.: H01L 21/768

(54) **VERFAHREN ZUR HERSTELLUNG VON HALBLEITERBAUELEMENTEN IN CMOS-TECHNIK MIT 'LOCAL INTERCONNECTS'**
METHOD OF MANUFACTURING CMOS SEMICONDUCTOR COMPONENTS WITH LOCAL INTERCONNECTS
PROCEDE DE FABRICATION DE COMPOSANTS SEMICONDUCTEURS DE LA TECHNIQUE CMOS AVEC DES 'INTERCONNEXIONS LOCALES'

(30) Priorität: 15.06.1992 DE 4219529
(43) Veröffentlichungstag der Anmeldung: 08.06.1994
(73) Patentinhaber: Micronas GmbH, 79108 Freiburg (DE)
(72) Erfinder: WILMSMEYER, Klaus, D-7819 Denzlingen (DE)
(74) Vertreter: Hornig, Leonore, Dr.
(86) Internationale Anmeldenummer: EP9301452
(87) Internationale Veröffentlichungsnummer: WO9326042

(56) Entgegenhaltungen:
- EP-A- 0 499 855
- ESSDERC 1989, BERLIN Seiten 903 - 906 M.G.PITT ET AL. 'ELECTRICAL CHARACTERIZATION OF SUBMICRON TITANIUM SILICON LOCAL INTERCONNECT TECHNOLOGIE' in der Anmeldung erw{hnt

## Beschreibung

Die Erfindung betrifft ein Verfahren nach dem Oberbegriff des Anspruchs 1.

Bei der fortgeschrittenen CMOS-Technik werden sogenannte "local interconnects" zur Erhöhung der Packungsdichte herangezogen. Man versteht darunter die Einführung von definierten Leitbahnen aus z.B. Polysiliciden nach der Source-Drain-lmplantation und vor der Abscheidung einer Zwischenoxidschicht. Es resultieren auf diese Weise vergrabene Kontakte, die eine direkte Verbindung zwischen der Polysiliciumschicht und den aktiven Bereichen ohne Metallverbindung ermöglichen.

Das übliche Verfahren zur Herstellung von "local interconnects" (nachfolgend als Ll bezeichnet) läuft zunächst mit den üblichen Schritten der CMOS-Herstellung ab. Nach der Source-Drain-lmplantation werden dann dünne Schichten eines hitzebeständigen Metalls wie z.B. Titan und alpha-Silicium in Form einer Doppelschicht aufgesputtert. Das alpha-Silicium wird dann in einem Photoprozeß entsprechend strukturiert und in einer Stickstoffatmosphäre getempert, so daß sich überall da wo Silicium und Metall in Berührung ist, das entsprechende Silicid ausbildet. Durch selektives Ätzen wird dann das nicht umgesetzte Metall und im Falle von Titan gegebenenfalls entstandenes Titannitrid entfernt und die Wafer einem zweiten Temperungsprozeß unterworfen, in dessen Verlauf das ursprüngliche C49-Silicid in das niederohmigere C54-Silicid übergeführt wird. Anschließend wird der herkömmliche CMOS-Prozeß mit Silox-BPSG-Beschichtung fortgeführt.

Bei diesen Verfahren werden außer der Bildung der Ll in einem selbstjustierenden Prozeß auch Source-, Drain- und Gate-Gebiete siliciert und damit niederohmiger gemacht (Salicide-Verfahren).

Besonders für kleine Strukturen weist das herkömmliche Verfahren jedoch eine Reihe von Nachteilen auf:

Der oben erwähnte Strukturierprozeß muß mittels anisotropen Ätzens (RIE) vorgenommen werden, um ein Unterätzen zu vermeiden. Dabei besteht aber die Gefahr, daß in den Gate-Ecken 9 sogenannte Filaments von alpha-Silicium stehenbleiben, die im Verlauf des weiteren Prozesses durch Bildung von Metallsilicid-Brücken Kurzschlüsse verursachen können. Will man dies vermeiden, muß stark überätzt werden, was wiederum den Nachteil hat, daß dabei ein Teil des Metalls abgetragen wird und somit dieses dann außerhalb der-Ll-Gebiete wesentlich dünner ist, als in den Bereichen, wo die "local interconnects" erzeugt werden. Das bedeutet aber, daß bei der anschließenden Silicidherstellung a) auf den erstengenannten Bereichen zu wenig Silicid sich ausbildet und diese damit hochohmig werden, und b) auf den Ll-Bereichen sich zuviel. Silicid bildet, mit der Gefahr von Verbindungsfehlern mit Sperrströmen. Siehe hierzu den Artikel "Electrical Characterization of Submicron Titanium Silicon Local Interconnect Technologie; ESSDERC 89 p.903) von M.G.Pitt et al in ESSDERC 89, Seite 903 ff, wo die erwähnte Problematik in Verbindung mit der Titansilicid-Bildung beschrieben wird.

Die Wirksamkeit der Entfernung des alpha-Silicium aus den Gate-Ecken durch Überätzen hängt wesentlich von der Form der Spacer ab, die die Ränder des eigentlichen Polysilicium-Gate isolieren. Die Spacerform und hier insbesondere deren Flankensteilheit unterliegt jedoch im allgemeinen Prozeßschwankungen, so daß die Zuverlässigkeit der Filament-Beseitigung nicht gegeben ist.

Die Silicidbildung bei der ersten Temperung ist zudem für die Nicht-Ll-Bereiche ein empfindlicher Prozeß, da er von zwei konkurierenden Reaktionen bestimmt wird. Ist nämlich das hitzebeständige Metall Titan, so bildet sich von der der Oberfläche her Titannitrid ausbilden und von der Trennfläche Titan/Silicium Titansilicid. Aus diesem Grund sind Prozeßschritte unerwünscht, welche die Oberfläche des reaktiven Titan unbeabsichtigt beeinträchtigen können so z. B. die obengenannten Schritte des Ätzens und Ablackens im Rahmen des Photoprozesses. Es ist zu befürchten, daß durch Verunreinigung, wozu auch eine Oxydation zählt, die Nitridbildung und ebenso auch die Silicidbildung unreproduzierbar werden.

Es stellt sich somit die Aufgabe, das eingangs genannte Verfahren derart abzuändern, daß ihm die genannten Nachteile nicht anhaften. Diese Aufgabe wird durch die in den Ansprüchen gekennzeichnete Erfindung gelöst.

Im folgenden wird die Erfindung anhand der lediglich ein Ausführungsbeispiel darstellenden Zeichnung näher erläutert, wobei in den einzelnen Figuren im Schnittbild die einzelnen Verfahrensschritte zusammengefaßt dargestellt sind und für gleiche Teile gleiche Bezugszeichen verwendet werden. Von den Figuren zeigen,
Fig. 1 bis Fig. 4 die herkömmlichen Schritte der Ll-Technik,
Fig. 5 bis 8 die Schritte im Rahmen der Erfindung zur Herstellung des Salicide-Teils,
die Figuren 9 bis 11 die Herstellung des Ll-Silicides.

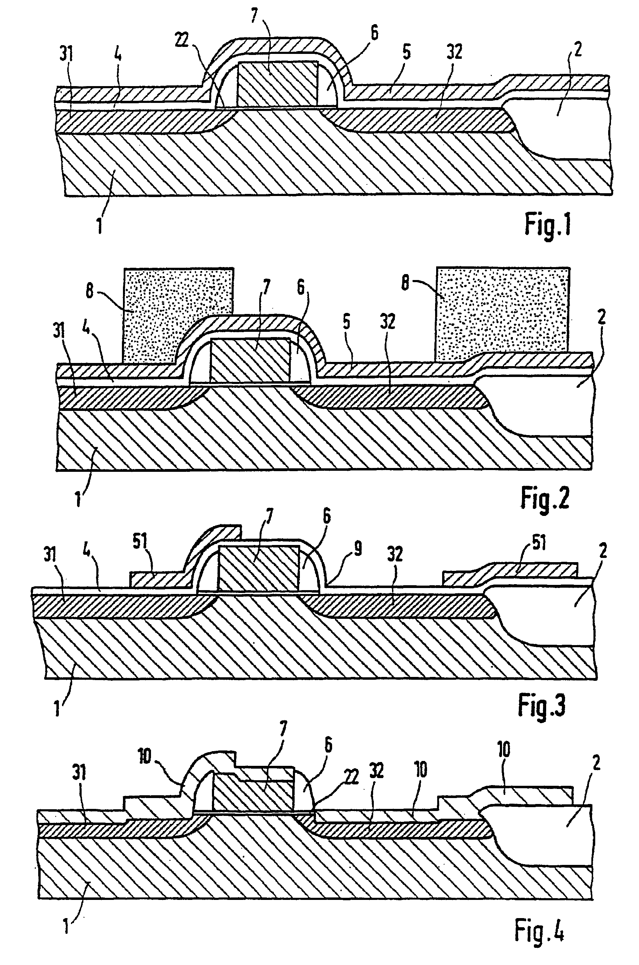

Bei der herkömmlichen Ll-Technologie wird zunächst der übliche CMOS-Prozeß bis nach der p+ Diffusion durchgeführt (Fig. 1). Die dabei erhaltene Struktur zeigt das Substrat 1 mit den Source/Drain-Gebieten 31, 32, dem Feldoxidbereich 2, dem Gate-Oxid 22, der Polysiliciumschicht 7 und den Spacern 6. Dieser Aufbau wird nun durch eine aufgesputterte Doppelschicht aus Titan 4 und amorphen Alpha-Silicium 5 abgedeckt.

In einem Photoprozeß wird dann das Photolackmuster 8 erzeugt, wodurch die Bereiche der späteren "local interconnects" festgelegt werden (Fig. 2). Anschließend wird durch anisotropes Ätzen (RIE) die freiliegende Siliciumschicht 5 bis zur Titanschicht abgetragen und danach die Ätzmaske (Photolackschicht 8) entfernt (Fig. 3).

Durch Tempern bildet sich an den Stellen, an denen die Titanschicht 4 mit Silicium in Berührung steht, eine Schicht 10 aus Titansilicid. Das als Konkurrenzreaktion gebildete Titannitrid sowie überschüssiges Titan wird selektiv durch Ätzen entfernt und in einem zweiten Temperungsprozeß das Silicid der C49-Konfiguration in das niederohmigere der C54 Kristallstruktur übergeführt (Fig. 4). Anschließend wird der Standard-CMOS-Prozeß mit der Silox-Bor-Phosphor-Silikatglas-Beschichtung fortgesetzt.

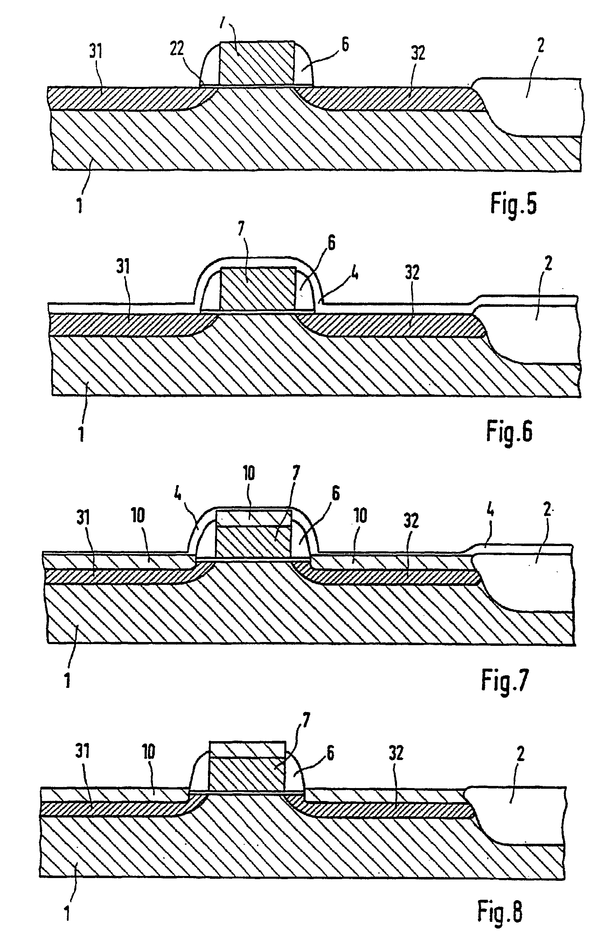

Bei dem erfindungsgemäßen Verfahren, das anhand der Figuren 5 bis 11 dargestellt ist, erfolgt eine Auftrennung der Verfahrensschritte in die Silicidbildung und in die Herstellung der "local interconnects". Ausgehend von einem n-dotierten Substrat 1 werden wiederum nach dem herkömmlichen CMOS-Prozeß Source-und Drain-Zonen 31, 32 eindiffundiert. Die letztlich resultierende Struktur ist in Fig. 5 gezeigt. Sie ist bis auf die fehlende Doppelschicht aus Titan 4 und amorphen Silicium 5 mit Fig. 1 identisch.

Im nächsten Verfahrensschritt wird auf der Oberfläche lediglich eine Titanschicht 4 aufgesputtert (Fig. 6). Danach wird durch Tempern bei 600°-800°C Titansilicid in den Bereichen erzeugt, in denen das Metall direkt auf Silicium aufliegt Schicht 10 in Fig. 7). Anschließend wird durch selektives Ätzen das nichtumgesetzte Titan entfernt und ein zweiter Temperungsschritt bei 800-1000 C durchgeführt, um den Flächenwiderstand des gebildeten Silicids weiter zu verringern (Fig. 8).

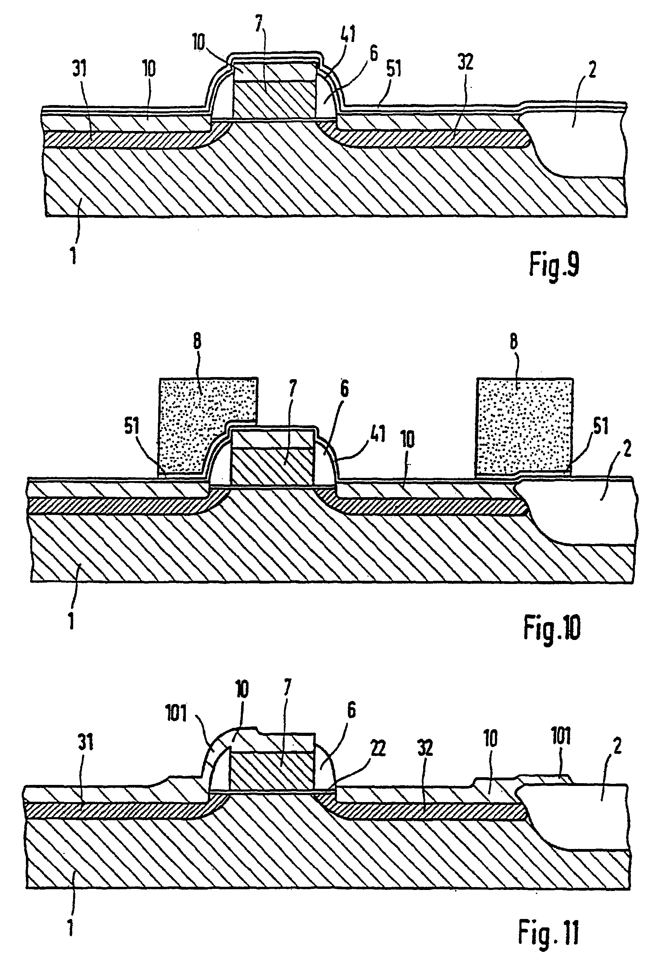

Nunmehr wird eine Doppelschicht aus Titan 41 und amorphen alpha-Silicium 51 aufgesputtert, welche wiederum die gesamte Oberfläche des Bauteils abdeckt (Fig. 9).

Die Festlegung der Ll-Bereiche erfolgt mittels eines Photoprozesses, wobei die verbleibende Ätzmaske die Bereiche abdeckt, in denen die Ll's erzeugt werden sollen. Nach dem Abätzen der alpha-Siliciumschicht 41 verbleibt die Struktur nach Fig.10. Anschließend wird die Ätzmaske (Photolackschicht 8) entfernt und zur Bildung von Trtansilicid in den Ll-Bereichen die Struktur einer Temperung bei 600-800°C unterworfen. Danach wird das nichtumgesetzte Titan durch Ätzen entfernt und in einem zweiten Temperungsschritt bei 800-1000°C der Flächenwiderstand des gebildeten Silicids herabgesetzt, Umwandlung von C49-Silicid in C54-Silicid (Fig. 11).

Im Anschluß an diese Schritte wird das Verfahren entsprechend dem Standard-CMOS-Prozeß weitergeführt.

Das erfindungsgemäße Verfahren weist zwar mehr Schritte auf als das bislang angewendete, Grund hierfür ist die angestrebte Entkopplung der Herstellung des Source/Drain/Gate-Silicid und die des Silicids für die Ll's, was jedoch nur ein scheinbarer Nachteil ist, denn man erreicht auf diese Weise eine ganze Reihe von Vorteilen. Im Gegensatz zum konventionellen Verfahren können die Schichtdicken der Metall- und der alpha-Siliciumschicht wesentlich dünner gehalten werden, da nur die Ll-Bereiche aus ihnen hergestellt werden. Man erreicht dadurch eine wesentlich höhere Zuverlässigkeit bei der Herstellung der Bauelemente.

Weitere Vorteile sind:

Durch die Auftrennung können beim Salicidverfahren, das in der Halbleitertechnik hinlänglich bekannt ist, der niedrige Flächenwiderstand beibehalten werden.

Die Zeit für das Überätzen des alpha-Siliciums kann wesentlich ausgedehnt werden und ist trotzdem unkritisch, weil das Metall außerhalb der Ll-Bereiche nicht mehr gebraucht wird.

Selbst eine starke Überätzung des alpha-Siliciums garantiert auch bei anisotropen Prozeß an steilen Kanten einen sicheren alpha-Silicium-Abtrag, so daß keine Reste in den Gate-Ecken verbleiben.

Durch die starke Überätzung ist unabhängig von der Form der die Gate-Kanten bildenden Spacer gewährleistet, daß das alpha-Silicium vollständig entfernt wird.

Die oben erwähnte Möglichkeit, die Doppelschicht aus Metall und alpha-Silicium relativ dünn zu halten, erlaubt eine kürzere Ätzzeit, was eine bessere Maßhaltigkeit der Struktur zur Folge hat.

Die Metallschicht zur Source/Drain/Gate-Silicidbildung muß vor dem Tempern nicht noch andere Prozesse durchlaufen. (Photoprozeß, Ablacken), die die eigentliche Silicidbildung stören können.

Das kleinere Angebot an Metall, im vorliegenden Beispiel Titan, vermeidet den sogenannten Silicon-Suckout-Effekt in den Bereichen der "local interconnects" und den aktiven Zonen.

## Patentansprüche

1. Verfahren zur Herstellung von CMOS-Bauelementen mit "local interconnects", **gekennzeichnet durch** folgende Verfahrensschritte:
a) Standard CMOS-Prozeß bis zur p+-Diffusion, bei welchem jeweils ein Source-, Drainund Gate-Gebiet erzeugt werden,
b) Aufsputtern einer Schicht (4) aus hitzebeständigem Metall,
c) Erste Temperung zur Ausbildung einer Metallsilicidschicht (10) auf dem Source-, Drain- und Gate-Gebiet,
d) Selektives Ätzen der nicht umgesetzten Metallschicht (4),
e) Zweite Temperung zur Verringerung des Widerstands der Metallsilicidschicht,
f) Aufsputtern einer weiteren Schicht (41) aus hitzebeständigem Metall und einer darüberliegenden Schicht (51) aus amorphem Alpha-Silicium zur Erzeugung der local interconnects,
g) Photolithographieprozeß zur Strukturierung der Siliciumschicht (51) mit Festlegung der local interconnect-Bereiche und nachfolgender Ablackung und erste Temperung zur Ausbildung der Metallsilicidschichten 101 für die local interconnects,
h) Abätzen der verbliebenen Metallschicht (41)
i) Zweite Temperung
j) Weiterführung des Standard-CMOS-Prozesses.

2. Verfahren nach Anspruch 1, **dadurch gekennzeichnet, daß** das hitzefeste Metall, Titan, Wolfram, Molybden oder Tantal ist.

## Claims

1. A method of fabricating CMOS devices with local interconnects, **characterized by** the following steps:
1. Standard CMOS process up to the p⁺ diffusion
2. Sputtering a layer (4) of heat-resistant metal
3. First annealing step for forming a metal-silicide layer (10)
4. Selective etching of the unconverted metal layer (4)
5. Second annealing step
6. Sputtering another layer (41) of heat-resistant metal and an overlying layer (51) of amorphous alpha silicon
7. Photolithographic process for patterning the silicon layer (51), followed by photoresist stripping, and first annealing step for forming the metal-silicide layers (101)
8. Etching away the remainder of the metal layer (41)
9. Second annealing step
10. Continuation of the standard CMOS process.

2. A method as claimed in claim 1, **characterized in that** the heat-resistant metal is titanium, tungsten, molybdenum or tantalum.

## Revendications

1. Procédé de fabrication de composants de la technique CMOS avec des "interconnexions locales", **caractérisé par** les étapes de procédé suivantes :
a. procédé CMOS standard jusqu'à la diffusion de P⁺,
b. dépôt par projection d'une couche (4) en métal réfractaire,
c. première trempe en vue de la formation d'une couche (10) de siliciure de métal,
d. attaque sélective de la couche (4) de métal non transformée,
e. deuxième trempe,
f. dépôt par projection d'une autre couche (41) en métal réfractaire et d'une couche (51) la recouvrant en silicium alpha amorphe,
g. processus de photogravure pour la structuration de la couche (51) de silicium avec élimination ultérieure du vernis et première trempe pour la formation de couches (101) de siliciure de métal,
h. élimination par attaque de la couche (41) de métal subsistant,
i. deuxième trempe,
j. continuation du procédé standard CMOS.

2. Procédé selon la revendication 1, **caractérisé en ce que** le métal réfractaire est du titane, du tungstène, du molybdène ou du tantale.
